# EUROPEAN PATENT APPLICATION

(11) **EP 1 732 209 A1**
(43) Date of publication of application: **13.12.2006**
(21) Application number: 06010186.2
(22) Date of filing: 17.05.2006
(51) Int. Cl.: H03F 3/08, H03F 1/32, H03F 1/22, H03F 3/50, H03F 1/30

(54) **Distortion cancellation in a transimpedance amplifier circuit**

(30) Priority: 09.06.2005 US 148022
(71) Applicant: Emcore Corporation, Albuquerque NM 87123 (US)
(72) Inventor: Kasper, Bryon Lynn, San Marino CA 91108 (US); Peral, Eva Maria, Alradena CA 91001 (US)
(74) Representative: Geyer, Ulrich F.

(57) **Abstract**

An optical receiver for use in an optical communications system in which an analog signal is transmitted over an optical fiber including a housing with a photodetector (PD1) coupled to the external optical fiber for receiving an optical communications signal; and a transimpedance amplifier (FET1,FET2) coupled to the electrical output of the photodetector (PD1) and having a bias current in a second stage (FET3) set to a predetermined value that minimizes the distortion in the output signal created in a first amplification stage (FET1,FET2) by a cancellation effect.

## Description

### BACKGROUND OF THE INVENTION

### 1. Field of the Invention

The invention relates to optical receivers, and in particular to transimpedence amplifiers that have a non-linear operating characteristic and provide an interface between a photodiode that receives an optical signal from an optical fiber, such as used in fiber optical communications links, and electronic network terminal units.

### 2. Description of the Related Art

A variety of optical communications systems are known in the art which include an optical transmit portion that converts an electrical signal into a modulated light beam that is coupled to an optical fiber, and a receive portion that receives an optical signal from an optical fiber and converts it into an electrical signal. Traditionally, optical receive sections include an optical assembly to focus or direct the light from the optical fiber onto a photodetector, which in turn, is connected to an amplifier/limiter circuit on a circuit board. The photodetector or photodiode is typically packaged in a hermetically sealed package in order to protect it from harsh environmental conditions. The photodiodes are semiconductor chips that are typically a few hundred microns to a couple of millimeters wide and 100-500 microns thick. The package in which they are mounted is typically from three to six mm in diameter, and two to five mm tall and has several electrical leads coming out of the package. These electrical leads are then soldered to the circuit board containing the amplifier/limiter and other circuits for processing the electrical signal.

Fiber optic transmission has been used for many years for the distribution of analog CATV signals. Optical receivers for analog CATV signals typically consist of a packaged photodiode electrically connected to a separately-packaged low-noise electronic amplifier, with the photodiode package usually consisting of a TO can with an optical window cap or a ball lens cap to allow light from an optical fiber to be coupled to the photodiode.

A disadvantage of the above arrangement is that there are significant parasitic capacitances associated with the separate photodiode and electronic amplifier packages. These parasitic capacitances play a role in limiting the performance of the optical receiver, resulting in lower bandwidth and higher noise, and contributing to higher power dissipation required to meet a particular target specification.

For digital optical receivers, the standard practice is to package the electronic amplifier (known as a transimpedance amplifier or TIA) inside the TO can next to the photodiode with no intervening packaging. In this way, parasitic capacitances are minimized and performance is improved. However, to date this has not been an option for analog CATV receivers because the power dissipation of the analog TIA has been too high for TO cans to dissipate. This high power dissipation occurs because analog CATV systems require extremely high linearity and low electrical distortion, which is achieved by operating the amplifying transistors with high quiescent currents and voltages so that the signal swing is limited to a small fraction of the available current or voltage excursion. These high quiescent voltages and currents lead to the high DC power dissipation of analog TIAs relative to digital TIAs.

Another technique that is common for analog TIAs is the use of a push-pull or balanced amplifiers, which cancel even-order distortion products, particularly second-order distortion, and make achieving the required linearity much easier. Push-pull amplifiers also come at the price of higher power dissipation, however, because two amplifiers are needed instead of just one single-ended amplifier, and also at the price of balanced-to-unbalanced transformers needed to interconnect to later single-ended stages.

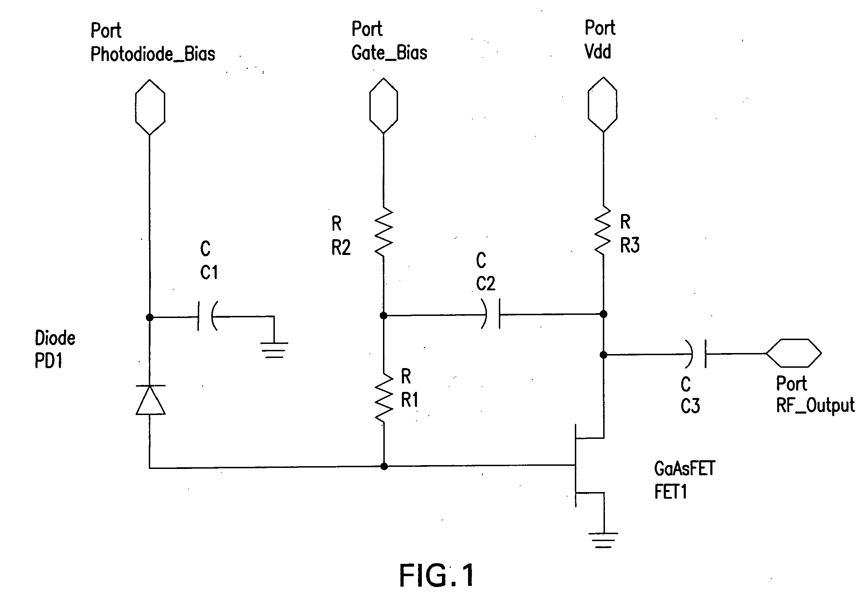

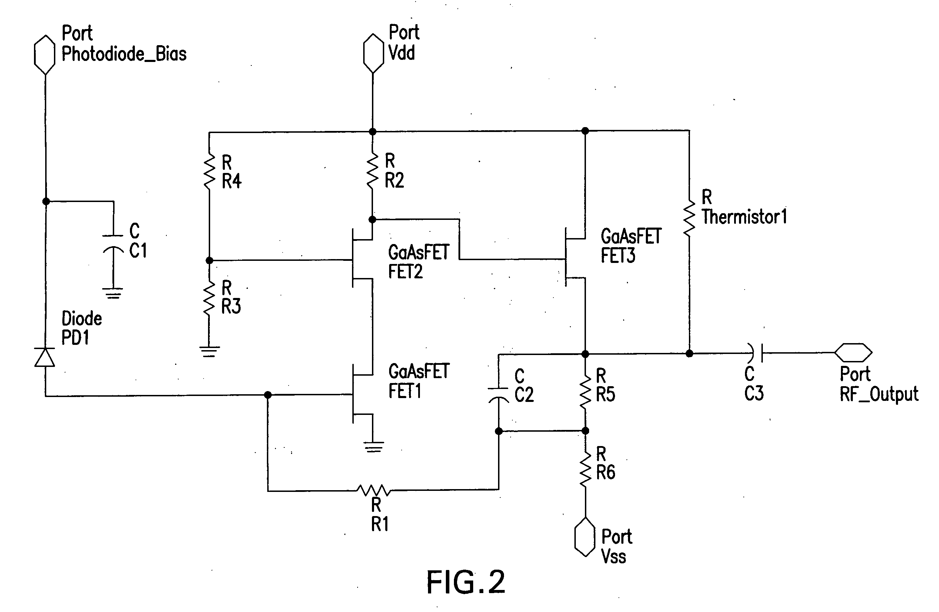

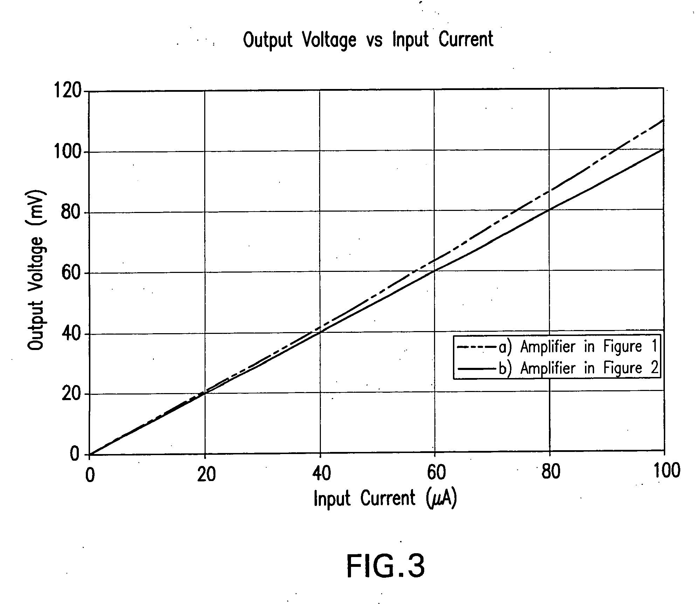

Examples of specific TIAs known in the prior art include U. S. Patent 4,998,012, which depicts a single GaAs FET input transistor configured as a transimpedance amplifier. Such circuit achieves low distortion by operating the transistor with a high drain voltage (15 V supply shown in Figure 1 of the patent) and with a high drain current (typically in the neighborhood of 100 mA) so that the signal AC excursion is a small percentage of the average DC operating point, hence the AC amplification is limited to a sufficiently linear operating region of the transistor.

Other prior art examples include U. S. Patent 5,013,903; U. S. Patent 5,179,461; and U. S. Patent 5,347,389. Such prior art uses two transimpedance amplifier stages connected to opposite ends of the photodiode, thereby amplifying approximately identical signals that are 180 degrees out of phase from each other. The outputs of the two transimpedance amplifier stages are combined together, typically by means of a transformer, so that the signals are added together in phase but even order distortion products subtract and are cancelled.

As noted above, however, the high power dissipation in all the prior art examples discussed precludes co-packaging of the TIA with a photodiode inside of a TO can or other low-cost package. The separate packaging of the photodiode and the TIA adds parasitic capacitance which reduces bandwidth, and increases noise and distortion.

Prior to the present invention, the high power dissipation of analog CATV TIAs, which is generally at least a watt or more, has made it impossible to package the TIA and photodiode together in a cost-effective way that would reduce the parasitic capacitance.

### SUMMARY OF THE INVENTION

### 1. Objects of the Invention

It is an object of the present invention to provide an integrated photodiode/ amplifier for use with optical network system units such as receivers and transceivers.

It is also another object of the present invention to provide an optical receiver subassembly for use in an optical transmission system within an industry standard TO housing.

It is an object of the present invention to provide an improved optical receiver using a low power dissipation amplifier subassembly that allows the photodiode/amplifier to be packaged in a TO can.

It is also another object of the present invention to provide a distortion cancellation circuit for use in non-linear amplifiers used in analog RF transmission systems.

It is still another object of the present invention to provide reduced heat dissipation in an optical receiver by providing an amplifier capable of operating at low power dissipation.

It is still another object of the present invention to provide a transimpedance amplifier with at least first and second stages, in which distortion in the second stage is opposite that of the first stage.

It is still another object of the present invention to provide a more generally applicable amplification function for broadband analog RF signal by means of an integrated circuit the employs internal distortion cancellation

### 2. Features of the Invention

Briefly, and in general terms, the present invention provides an optical receiver for converting and coupling an information-containing optical signal from an optical fiber, including a photodiode subassembly in the housing for converting an optical signal into a modulated electrical signal corresponding to the optical signal; and an amplifier subassembly in the housing.

Additional objects, advantages, and novel features of the present invention will become apparent to those skilled in the art from this disclosure, including the following detailed description as well as by practice of the invention. While the invention is described below with reference to preferred embodiments, it should be understood that the invention is not limited thereto. Those of ordinary skill in the art having access to the teachings herein will recognize additional applications, modifications and embodiments in other fields, which are within the scope of the invention as disclosed and claimed herein and with respect to which the invention could be of utility.

### BRIEF DESCRIPTION OF THE DRAWINGS

These and other features of this invention will be better understood and more fully appreciated by reference to the following detailed description when considered in conjunction with the accompanying drawings, wherein:
FIG. 1 is a schematic diagram of an optical receiver/amplifier in an exemplary embodiment in accordance with the prior art;
FIG. 2 is a schematic diagram of an optical receiver/amplifier in an exemplary embodiment in accordance with the present invention;
FIG. 3 illustrates representative output voltage versus input current characteristics of the circuits in Figures 1 and 2. It may be noted that Curve (a) of Figure 3, which corresponds with an exemplary V vs. I characteristic of the prior art circuit in Figure 1, shows a slight upward curvature as the input current increases, resulting in a deviation from linearity and causing the output voltage from the circuit in Figure 1 to exhibit second-order distortion. In contrast, Curve (b) in Figure 3, which corresponds with an exemplary V vs. I characteristic of a circuit in accordance with the present invention as illustrated in Figure 2, shows a linear V vs. I characteristic which does not produce distortion.
FIG. 4 is a diagram of measured distortion characteristics of the circuit in Figure 2 as a function of the drain-source current in the output source follower FET3 at a number of temperatures. It may be noted that there is an optimum source follower drain current which minimizes the second-order distortion, and which varies as a function of temperature.

The novel features and characteristics of the invention are set forth in the appended claims. The invention itself, however, as well as other features and advantages thereof, will be best understood by reference to a detailed description of a specific embodiment, when read in conjunction with the accompanying drawings.

### DESCRIPTION OF THE PREFERRED EMBODIMENT

Details of the present invention will now be described, including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of actual embodiments or the relative dimensions of the depicted elements, and are not drawn to scale.

For new Fiber-to-the-Home (FTTH) applications that include an analog optical CATV receiver at each customer premise, there is a strong desire on the part of network interface hardware manufacturers and service providers (such as telephone or cable operating companies) to reduce power dissipation and to lower hardware cost. To this end, the present invention provides a new design for a single-ended analog TIA with power dissipation low enough to allow TO packaging, but performance adequate to meet demanding CATV specifications. A key feature of this design is internal distortion cancellation, in which later amplifier stages have distortion characteristics that are the opposite of those of earlier stages, resulting in an overall amplifier with low distortion but without the high power dissipation that would be the result if each stage individually had to meet tight distortion requirements.

The invention provides a low-noise, low-distortion amplifier that can be used as either a preamplifier or postamplifier for the analog CATV portion of FTTH systems. The low power dissipation of the amplifier is unique in that it allows the preamplifier to be packaged together with a photodiode in a TO can, thereby reducing input capacitance and improving system performance. Low distortion is achieved by employing an output buffer stage with distortion properties that are the opposite of those of the input stage, resulting in distortion cancellation. Temperature compensation of the output-stage bias current can be used to optimize the performance. The invention provides competitive advantages in terms of noise, distortion, power dissipation , and cost relative to other FTTH analog receiver solutions.

A schematic diagram of this invention is shown in Figure 2. It consists of a three-transistor amplifier with the first two transistors (FET1 and FET2) connected as a cascodestage, and the third transistor (FET3) connected as a source follower. This configuration is commonly used for wideband amplifiers and can be found in textbooks such as Design and Applications of Analog Integrated Circuits, S. Soclof, Prentice Hall, Englewood Cliffs, NJ, 1991, p. 664. The circuit forms an optical receiver transimpedance amplifier with photodiode PD1 connected to the input, and a feedback resistor R1 connected between the input and output. The transistors used are GaAs PHEMT devices that have low noise, high bandwidth, and high linearity, which are the three primary requirements for circuit operation.

During SPICE simulations of the above circuit, distortion properties were found to be strongly dependent upon transistor current and voltage bias conditions. Under optimal bias conditions, however, both the second and third order distortion were extremely low. The associated power dissipation was much lower than that required for similar distortion performance with single-transistor PHEMT amplifiers.

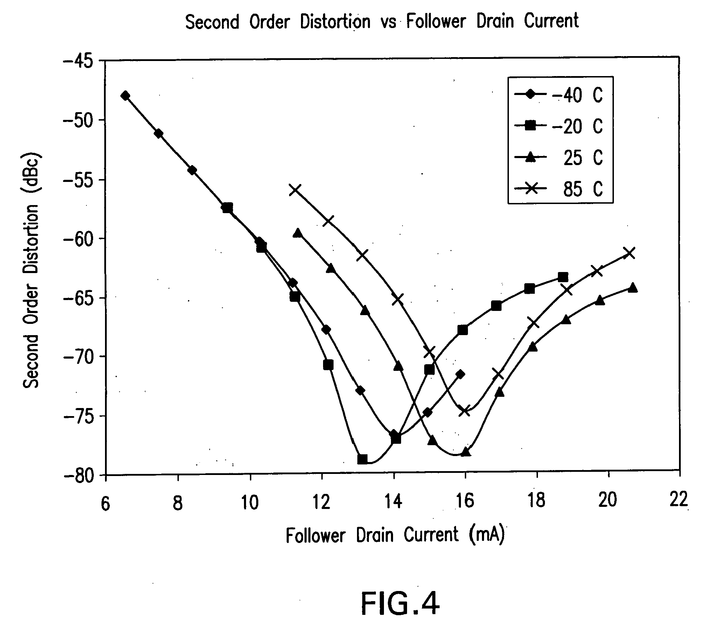

It has been found through both simulation and measurements of actual circuits that second-order distortion can be minimized by choosing an optimum drain-source current for the output source follower, FET3. An example of typical results is shown in Figure 4. Curves of second order distortion vs. FET3 drain-source current are plotted for four different temperatures. In each case, an optimum value of drain-source current is found that minimizes the second order distortion. The minimum occurs because FET3 has a distortion characteristic that is the opposite of the distortion introduced by the combination of FET1 and FET 2, and at the optimum current a cancellation effect occurs that minimizes the total distortion. The optimum current for lowest distortion, as shown in Figure 4, varies as a function of temperature. It is therefore possible to optimize the performance by adding temperature compensation to the circuit biasing. In Figure 2, one method to perform this temperature compensation is illustrated by the addition of the element Thermistor1 in parallel with FET3. A thermistor with the correct resistance value and temperature coefficient could be used in this location to minimize the receiver distortion over a particular operating temperature range. Numerous other means of temperature compensation are also possible, including temperature-controlled variation of the supply voltages Vdd or Vss, and also temperature-controlled variation of the drain-source bias current of FET1 and FET2. Varying each of the above has the direct or indirect effect of varying the drain-source current of FET3, and may be used to tune the overall receiver distortion. Temperature compensation could be accomplished using either positive or negative temperature coefficient thermistors, or by using temperature-dependent digital potentiometers that are typically controlled through the use of an internal digital look-up table. Other well-known means of temperature compensation such as using the temperature-dependent junction voltages of diodes or a digital microcontroller are also available.

The low power dissipation of the above circuit relative to current products would allow the analog TIA to be packaged in a TO can together with the photodiode, significantly improving the noise and bandwidth performance for a given power dissipation.

In addition to its application as an analog transimpedance amplifier, the invention can also be used as an RF amplifier. As such, it works as a postamplifier for FTTH CATV systems and may be widely usable in a variety of CATV and general RF applications where high linearity and low power dissipation are required.

Attached modifications and improvements of the present invention may also be apparent to those of ordinary skill in the art. Thus, the particular combination of parts described and illustrated herein is intended to represent only certain embodiments of the present invention, and is not intended to serve as limitations of alternate devices within the spirit and scope of the invention.

It will be understood that each of the elements described above, or two or more together, also may find a useful application in other types of constructions differing from the types described above.

While the invention has been illustrated and described as embodied in a amplifier circuit for an optical receiver in an optical communications network, it is not intended to be limited to the details shown, since various modifications and structural changes may be made without departing in any way from the spirit of the present invention.

Without further analysis, the foregoing will so fully reveal the gist of the present invention that others can, by applying current knowledge, readily adapt it for various applications without omitting features that, from the standpoint of prior art, fairly constitute essential characteristics of the generic or specific aspects of this invention, and therefore, such adaptations should and are intended to be comprehended within the meaning and range of equivalence of the following claims.

## Claims

1. In optical communications system in which an analog signal is transmitted over an optical fiber, an optical receiver comprising:
a photodetector coupled to an external optical fiber for receiving an optical communications signal; and
a transimpedance amplifier coupled to the electrical output of the photodetector and having first and second stages, wherein the bias current in a second stage is selected to minimize the distortion in the output signal created in the first amplification stage.

2. An optical receiver as defined in claim 1, wherein the analog signal is a wideband RF signal.

3. An optical receiver as defined in claim 1, wherein the first stage of the amplifier includes two transistors connected as a cascode amplifier, and the second stage includes a third transistor connected as a source follower.

4. An optical receiver as defined in claim 3, wherein the three transistors are GaAs PHEMT devices.

5. An optical receiver for use in an optical communication system comprising:
an integral housing including a window or opening in the housing for coupling the receiver to an external optical fiber for receiving an optical communications signal;
a photodetector in the housing for converting said optical signal into an electrical signal; and
a transimpedance amplifier in the housing coupled to the electrical output of the photodetector.

6. An optical receiver as defined in claim 5, wherein the optical signal is an analog video signal.

7. An optical receiver as defined in claim 5, wherein the housing is a low-cost package such as a TO can having a plurality of pins for electrical connection of the receiver to an external circuit.

8. An optical receiver as defined in claim 5, wherein the transimpedance amplifier includes at least first and second stages, and wherein distortion is introduced in the amplification process in the first stage and cancelled in the second stage.

9. An optical receiver as defined in claim 5, wherein the amplifier utilizes transistors with low noise, high bandwidth, and high linearity.

10. A transimpedence amplifier comprising a first stage and a second stage, wherein the second stage minimizes the distortion created by the first stage.

11. An amplifier as defined in claim 10, wherein said first stage is configured in a cascode arrangement of two field effect transistors for amplifying an electrical input signal from a photodiode.

12. An amplifier as defined in claim 10, wherein said first and second stages have predetermined signal distortion characteristics, with the distortion characteristic of the second stage being approximately opposite that of said first stage.

13. An amplifier as defined in claim 10, wherein the second stage is a transistor connected as a source follower, and the bias current in a second stage is selected to minimize the distortion in the output signal created in the first amplification stage.

14. An amplifier as defined in claim 13, wherein the bias current is selected as a function of temperature in order to minimize the distortion in the output signal created in the first amplification stage.

15. An amplifier as defined in claim 11, wherein the input signal is a wideband RF signal, and the first stage produces second order distortion in the amplified RF signal.
